# EUROPEAN PATENT APPLICATION

(11) **EP 0 973 190 A2**
(43) Date of publication of application: **19.01.2000**
(21) Application number: 99305342.0
(22) Date of filing: 06.07.1999
(51) Int. Cl.: H01L 21/322

(54) **Silicon wafer and method for producing it**

(30) Priority: 13.07.1998 JP 21347698
(71) Applicant: SHIN-ETSU HANDOTAI COMPANY LIMITED, Chiyoda-ku Tokyo (JP)
(72) Inventor: Kobayashi, Norihiro, c/o Isobe R & D Center, Annaka-shi, Gunma-ken, (JP); Akiyama, Shoji, c/o Isobe R & D Center, Annaka-shi, Gunma-ken, (JP)
(74) Representative: Cooper, John

(57) **Abstract**

A method for producing a Si wafer comprising at least a step of subjecting Si wafer to extrinsic gettering and a step of subjecting Si wafer to a heat treatment in a reducing atmosphere. There are provided a method for producing Si wafer characterized in that gettering effect is not lowered even when the heat treatment at high temperature in a reducing atmosphere such as hydrogen anneal or the like is performed, and thus COPs can be surely eliminated, and a Si wafer having no COPs and having an excellent gettering effect.

## Description

### BACKGROUND OF INVENTION

### Field of the Invention:

The present invention relates to Si wafer and a method for producing it. More particularly, the present invention relates to Si wafer having less COPs (Crystal Originated Particle) and excellent gettering effect, which can be used suitably for a semiconductor device or the like, and a method for producing it.

### Description of the Related Art:

In order to improve electric characteristics such as oxide dielectric breakdown voltage of a silicon wafer, it is necessary to make the surface layer portion of the wafer on which a device is fabricated defect-free. However, crystal defects called COP which have a regular octahedron structure are sometimes incorporated into a single crystal during growth of silicon single crystal, and thus they exist in the surface layer of the silicon wafer obtained from the single crystal. Such COPs may degrade electric characteristics of the silicon wafer.

In order to remove the COPs, heat treatment at high temperature such as hydrogen anneal or the like has been conventionally conducted. Although COPs can be eliminated by the above-mentioned heat treatment at high temperature, nuclei of bulk micro defect (hereinafter occasionally referred to as "BMD" or "oxide precipitates") are also eliminated by the treatment. As a result, oxide precipitates cannot be generated at the heat treatment at high temperature, so that gettering effect may be significantly lowered in a device process. Furthermore, oxide precipitates are never increased after the above-mentioned heat treatment at high temperature even if the heat treatments are then performed, and thus gettering effect can be hardly recovered.

Meanwhile, there are various steps in a device process, and an apparatus which may generate metal contamination in the wafer is occasionally used in some of the steps. In that case, the wafer processed in the apparatus may suffer the metal contamination. However, in general wafers, BMD grows due to several heat treatments in a device fabricating process, oxide precipitates are increased, and thus gettering effect is increased. As a result, even if the wafer suffers metal contamination in the device fabricating process, the metal impurities can be eliminated to some extent.

However, in the wafer subjected to the heat treatment at a high temperature in a reducing atmosphere as mentioned above, gettering effect cannot be recovered and is still very low even if the wafer is subjected to the heat treatments afterward. Therefore, metal impurities in the wafer cannot be removed, but remain. The impurities may lower the oxide dielectric breakdown voltage, and may increase leakage current in P-N junction. As a result, yield in the device fabrication may be lowered.

### SUMMARY OF THE INVENTION

The present invention has been accomplished to solve the above-mentioned problems, and an object of the present invention is to provide a method for producing Si wafer wherein gettering effect is not lowered even when the heat treatment at high temperature in a reducing atmosphere such as hydrogen anneal or the like is performed, and thus COPs can be surely eliminated, and to provide Si wafer having no COPs and having an excellent gettering effect.

To achieve the above object, the present invention relates to a method for producing a Si wafer comprising at least a step of subjecting a Si wafer to extrinsic gettering (hereinafter occasionally referred to as "EG"), and a step of subjecting a Si wafer to a heat treatment in a reducing atmosphere (hereinafter occasionally referred to as "a reducing heat treatment").

If the Si wafer is subjected to EG, gettering effect can be afforded to Si wafer even in the case that the wafer is subjected to a reducing heat treatment at high temperature. Furthermore, COPs on the surface of the wafer can be surely eliminated by the above-mentioned reducing heat treatment.

The present invention also relates to a method for producing a Si wafer wherein a step of subjecting a Si wafer to a heat treatment in a reducing atmosphere is performed after a step of subjecting a Si wafer to extrinsic gettering.

The effect of eliminating COPs by the reducing heat treatment is larger at a position that is closer to the surface of the wafer. Meanwhile, when EG is performed according to Poly-silicon Back Seal method (hereinafter occasionally referred to as "PBS") which will be described later, it is sometimes necessary to perform polishing or to remove contamination on the surface of the wafer afterward. Accordingly, if EG is performed after the reducing heat treatment, no defect layer containing no COP formed on the surface of the wafer by the reducing heat treatment may be partly removed by the polishing or the like performed afterward. On the other hand, the effect of improving the gettering effect is hardly lowered by the reducing heat treatment performed afterward. This is the reason why it is advantageous that the reducing heat treatment is performed after EG.

The above-mentioned extrinsic gettering may preferably be performed according to Poly-silicon Back Seal method in the above-mentioned method for producing Si wafer.

When EG is performed according to PBS, generation of slip dislocation can be suppressed even in the case that the heat treatment at high temperature is performed afterward.

Preferably, the heat treatment in a reducing atmosphere is performed with a rapid thermal annealer (hereinafter occasionally referred to as "RTA") in the above-mentioned method for producing Si wafer.

If the reducing heat treatment is performed with RTA, COPs can be eliminated, and furthermore, heat treatment time, amount of reducing gas and energy consumption can be saved, so that production efficiency can be improved.

It is preferable that the above-mentioned heat treatment in a reducing atmosphere is performed in an atmosphere of 100% hydrogen or a mixed atmosphere of hydrogen and an inert gas at 1150 to 1350°C for one to 300 seconds.

The above-mentioned condition has been revealed to be optimum as a result of further study of the condition for the reducing heat treatment by the inventors of the present invention.

The present invention also relates to Si wafers produced according to the above-mentioned methods.

In the Si wafer thus produced, the number of COPs per a wafer having a size of 8 inches is very small as 50 or less (0.16 number/cm² or less), and the gettering effect is high.

Particularly, in the wafer subjected to such a heat treatment, the number of COPs in the surface layer of the wafer is small, there exists no gettering layer in the bulk of the wafer, but exists in the back surface of the wafer, so that the wafer haivng very few defects in the front surface layer on which a device is formed can be obtained.

More specifically, the present invention provides Si wafer wherein a density of COP on the front surface of the wafer is 0.16 number/cm² or less, a density of bulk defects (bulk micro defects) in the bulk of the wafer is 1 x 10⁹ number/cm³ or less, and a polysilicon layer having a thickness of 0.5 µm or more exists in the back surface of the wafer.

According to the method for producing Si wafer of the present invention, COPs can be surely eliminated by the heat treatment at high temperature such as hydrogen anneal without lowering the gettering effect. Moreover, in the Si wafer of the present invention, there is almost no COP therein, and the gettering effect is hardly to be lowered. Furthermore, generation of slip dislocation can be suppressed due to formation of the polysilicon film.

### BRIEF DESCRIPTION OF THE DRAWINGS

Fig.1 is a graph showing the relationship between the reducing heat treatment temperature and the bulk defect density;
Fig.2 is a graph showing a result of measurement of oxide dielectric breakdown voltage of MOS capacitor fabricated using Si wafers produced with performing PBS and with or without performing RTA;
Fig.3 is a graph showing generation of slip dislocation after RTA heat treatment in each of Si wafer produced with or without performing PBS;
Fig.4 is a schematic sectional view of RTA.

### DESCRIPTION OF THE INVENTION AND A PREFERRED EMBODIMENT

The present invention will be further described below in detail, but is not limited thereto.

The method for production according to the present invention comprises at least a step of subjecting a Si wafer to EG and a step of subjecting a Si wafer to a reducing heat treatment. The Si wafer can be, for example, a wafer obtained by slicing a silicon single crystal ingot grown by Czochralski method (CZ method), and then by chamfering, lapping, etching, and polishing or the like, if necessary.

The above-mentioned EG can increase the gettering effect of the wafer. Examples of EG include: PBS, a sand blasting method, a phosphorus gettering method or the like. PBS is preferable, since it has high effect of increasing the gettering effect, and it can suppress generation of slip dislocation even when the heat treatment at a high temperature is performed afterward. The sand blast method is possible, but it may contaminate the surface of the wafer.

EG according to PBS can be performed, for example, as follows.

First, a thin oxide film is previously formed on the back surface of the silicon wafer, if necessary. In order to form the oxide film, the thin oxide film can be grown by cleaning with a cleaning solution containing hydrogen peroxide or ozone, or other conventional methods such as thermal oxidation, a chemical vapor phase growing method or the like can be performed.

Next, a polysilicon film is formed on the back surface according to, for example, a low-pressure chemical vapor phase growing method or the like. As an apparatus therefor, a general low-pressure chemical vapor phase growing furnace can be used. The temperature in the furnace is, preferably 600 to 700°C, and the pressure in the furnace is preferably 0.1 to 0.3 torr. Gas as a raw material can be, for example, SiH₄ or the like. Thickness of the film can be, for example, 0.5 to 1.5 µm.

In the case that only one nozzle for the gas as a raw material is used, temperature gradient in the furnace can be made in order to make the thickness of the film uniform. Alternatively, the plural nozzles, for example, four or five nozzles can be used for gas as raw material. In that case, deposition of the film with uniform thickness can be achieved without making the temperature gradient in the furnace, but with keeping the temperature in the furnace constant and optimizing the amount of gas flow. Thereby, uniform quality such as orientation of the crystal can also be achieved, since the temperature in the furnace is constant.

The method for production of the present invention can further comprise a step of subjecting the Si wafer to the heat treatment in a reducing atmosphere. Thereby, COPs can be eliminated in the surface of the wafer. The reducing atmosphere can be 100% hydrogen or a mixed atmosphere of hydrogen gas and an inert gas. A mixed atmosphere of hydrogen gas and an inert gas is preferable. The inert gas can be, for example, argon, nitrogen or the like. Hydrogen gas concentration in the mixed atmosphere can be preferably 10 to 80 % by volume, especially 20 to 40 % by volume. When the concentration of hydrogen gas is too low, COPs cannot be sufficiently eliminated. When the concentration of hydrogen gas is too high, slip dislocation may be generated.

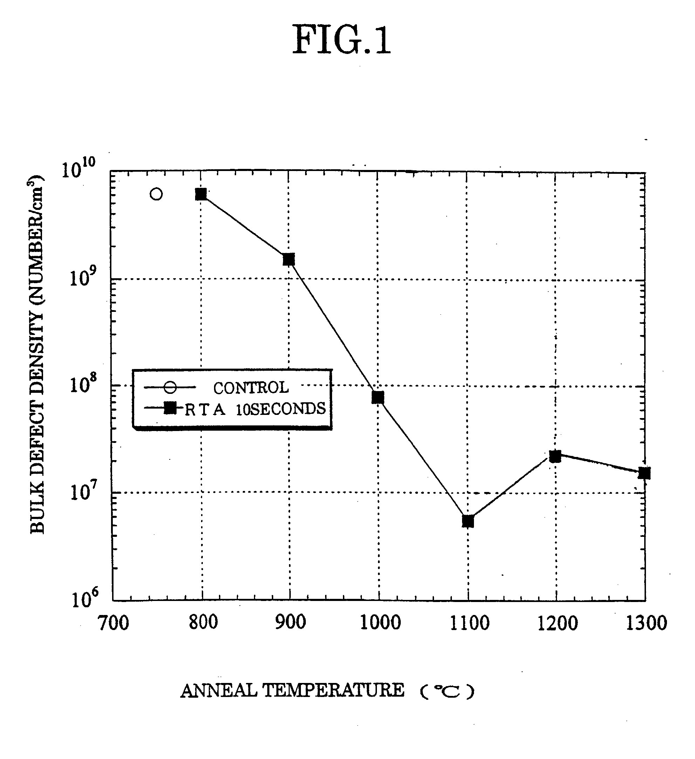

The heat treatment temperature can be, for example, from 900°C to a melting point of silicon. When the heat treatment temperature is too low, it takes long time to sufficiently eliminate COPs. Therefore, the range of 1150 to 1350°C is preferable. As shown in Fig.1 showing the relationship between the reducing heat treatment temperature and the bulk defect density (oxide precipitate density), when the heat treatment temperature is lower than 900°C, Si wafer has the bulk defect density of at least about 1 x 10⁹ number/cm³ which is a density generally necessary for gettering in the device process. When the heat treatment at 900°C or more is performed in a reducing atmosphere, the problem of low gettering effect may be caused. Namely, higher heat treatment temperature may increase the effect of eliminating COPs, but may decrease the bulk defect density, which may lead to significantly lowered gettering effect. Accordingly, when the reducing heat treatment is performed at a temperature of 1150 to 1350°C, COPs on the surface of the wafer can be sufficiently eliminated, and gettering effect becomes sufficient when the wafer is subjected to the above-mentioned EG.

The heat treatment time may be several hours or less in the case that the reducing heat treatment is performed using a general heat treatment furnace. In the case that the heat treatment is performed using RTA, the heat treatment time is preferably one to 300 seconds. When RTA is used, COPs can be sufficiently eliminated with such a short heat treatment time. However, when the heat treatment time is too short, COPs cannot be sufficiently eliminated. When the heat treatment time is too long, production efficiency may be lowered. Accordingly, the above-mentioned range of one to 300 seconds is preferable.

The above-mentioned reducing heat treatment can be performed in a single step or in multiple steps. When it is performed in multiple steps, for example, the former step may be performed at a high temperature of 1200°C or more for one to 300 seconds, and the latter step may be performed at lower temperature for one to 300 seconds. Thereby, COPs can be surely eliminated in the former step at higher temperature, and micro roughness, haze or the like on the surface of the Si wafer can be reduced while COPs are still eliminated in the latter step. As a result, there can be produced a device which is excellent in not only oxide dielectricbreakdown voltage but also electric characteristics such as mobility of P type or N type carrier or the like.

As described above, the reducing heat treatment is preferably performed with rapid heating/rapid cooling apparatus in the light of production efficiency or the like. "Rapid heating/rapid cooling" herein means a method that a wafer is immediately loaded into a heat treatment furnace in which a temperature is arranged in the above-mentioned range, and is immediately loaded out upon elapse of the above-mentioned heat treatment time, or a method that a wafer is immediately subjected to heat treatment with a lamp heater or the like after it is arranged at a predetermined position in the heat treatment furnace.

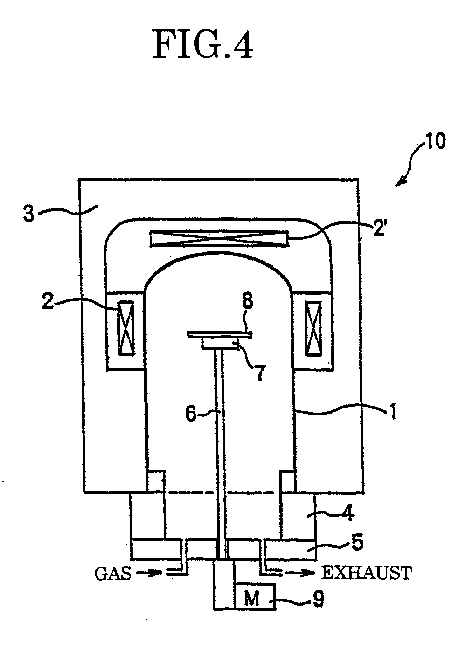

Such rapid heating/rapid cooling can be performed using RTA apparatus or the like. Examples of RTA apparatus include SHS-2800 manufactured by AST corp., which is commercially available, or the like. One example of rapid heating/rapid cooling of a Si wafer with RTA apparatus is specifically described below, referring to Fig.4.

First, inside of a bell jar 1 is heated with heaters 2 and 2' at a desirable temperature, for example, at 1150 to 1350°C, and the temperature is maintained. When the above-mentioned heat treatment in multiple steps is performed, power can be supplied independently to each of the heaters that are separated into two, and a temperature distribution can be established within the bell jar 1 along a vertical direction. Thereby, the lower temperature region for the latter step can be provided below the higher temperature region for the former step in this stage. Accordingly, the heat-treatment of a wafer in multiple steps can be easily performed by controlling the position of the stage 7, i.e. the amount of insertion of the support shaft 6 into the furnace.

In a state in which the interior of the bell jar 1 is maintained at a desired temperature, and the desired gas atmosphere is achieved by inserting a reducing gas from gas inlet provided in the base plate 5, a Si wafer is inserted into the water-cooled chamber 4 through the wafer port by an unillustrated wafer handling apparatus arranged next to the heat treatment furnace 10. The Si wafer is placed in, for example, a SiC boat provided on the stage 7 that is situated at the bottom standby position. Since the water-cooled chamber 4 and the base plate 5 are water-cooled, the wafer located at this standby position is not heated to a high temperature.

Upon completion of placing the Si wafer on the stage 7, the motor 9 is immediately driven to insert the support shaft 6 into the furnace so that the stage 7 is raised to a heat treatment position where a desired temperature in the range of 1150 - 1350°C is established, thereby heat-treating the Si wafer on the stage at the high temperature. In this case, since only approximately 20 seconds, for example, is required for moving the stage 7 from the bottom position in the wafer-cooled chamber 4 to the desired heat treatment position, the Si wafer is heated quickly.

The stage 7 is halted at the desired temperature position for a predetermined time (for example, one second to 300 seconds), thereby subjecting the wafer to high-temperature heat treatment over the halting time. Upon elapse of the predetermined time to complete high-temperature heat treatment, the motor 9 is immediately driven to withdraw the support shaft 6 from the interior of the furnace to thereby lower the stage 7 to the bottom position in the water-cooled chamber 4. This lowering motion can be completed in approximately 20 seconds, for example. The Si wafer on the stage 7 is quickly cooled, since the water-cooled chamber 4 and the base plate 5 are water-cooled. Finally, the wafer is unloaded by the wafer handling apparatus, thus completing the heat treatment.

When there are more wafers to be heat-treated, these wafers can be sequentially loaded into and heat-treated, since the RTA apparatus 10 is maintained at high temperature.

The reducing heat treatment is preferably performed after EG in the method of the present invention. COP eliminating effect of the reducing heat treatment is larger at a position closer to the surface of the wafer. On the other hand, when EG is performed according to the above-mentioned PBS, it is sometimes necessary to polish the wafer later in order to remove the polycrystal film extending to the front surface side. Accordingly, if EG is performed after the reducing heat treatment, no defect layer containing no COP formed on the surface of the wafer by the reducing heat treatment may be removed by the polishing or the like performed afterward. On the other hand, the effect of improving the gettering effect due to EG is hardly lowered by the reducing heat treatment performed afterward. This is the reason why it is advantageous that the reducing heat treatment is performed after EG.

However, if the special treatment of the surface of the wafer such as the above-mentioned polishing or the like is not necessary after EG treatment, and the surface of the wafer is not contaminated in EG, EG may be performed after the reducing heat treatment.

In the method for production according to the present invention, any further appropriate heat treatments other than the reducing heat treatment can be performed, if necessary, in order to actually increase the gettering effect. Furthermore, treatments generally performed in production of Si wafer, such as lapping, etching, mirror polishing or the like may be performed.

The Si wafer produced by the above-mentioned method for producing Si wafer according to the present invention contains 50 or less of COPs per a wafer having a size of 8 inches (0.16 number/cm² or less). Furthermore, the gettering effect is hardly lowered in the wafer.

### [Examples]

The present invention will be specifically explained in the following examples.
Relation between the heat treatment temperature in RTA H₂-anneal and the bulk defect density (number/cm³)

Si wafers of p-type having a diameter of 200 mm, resistivity of 10 Ω · cm, and an oxygen concentration of 16 ppma were subjected to hydrogen anneal with RTA at each temperature of 800°C, 900°C, 1000°C, 1100°C, 1200°C, 1300°C for 10 seconds.

In the present invention, oxygen concentration is measured by infrared spectroscopy according to a method adopted in JEIDA (Japan Electronics Industry Development Association).

The bulk defect density of the Si wafer subjected to each of hydrogen anneal treatments were determined by subjecting the wafer to the heat treatment at 800 °C in an atmosphere of nitrogen for 4 hours and then to the heat treatment at 1000 °C in an atmosphere of oxygen for 16 hours, and observing the bulk of the wafer to the depth of 90 µm from the surface according to an infrared interference method, more specifically by OPP (Optical Precipitate Profiler). The results were shown in Fig.1. The bulk defect density of the Si wafer that was not subjected to the hydrogen anneal was also shown in Fig.1 as a control.

As shown in Fig.1, when the heat treatment temperature in hydrogen anneal was more than 900°C, the bulk defect density was significantly decreased compared to that of the control that was not subjected to the hydrogen anneal, and may cause a problem of gettering effect.

### (Example 1)

On the Si wafers of p-type having a diameter of 200 mm, resistivity of 10 Ω · cm, and an oxygen concentration of 16 ppma were deposited a polysilicon film through use of low pressure chemical vapor pahse growth furnace, and PBS was performed. The temperature in the furnace was 650°C, the pressure in the furnace was 0.2 torr. SiH₄ was used as a raw material gas. The thickness of the film was 1.0 µm.

The Si wafer subjected to the above-mentioned PBS treatment was then subjected to the heat treatment in a reducing atmosphere. The reducing heat treatment was performed with RTA in the mixed atmosphere of 40 % by volume of hydrogen and argon at a temperature of 1200°C for 30 seconds.

Then, the surface of the above-mentioned Si wafer was intentionally contaminated by Ni in order to determine the gettering effect of the Si wafer. The contamination concentration was 1.0 x 10¹² atoms/cm².

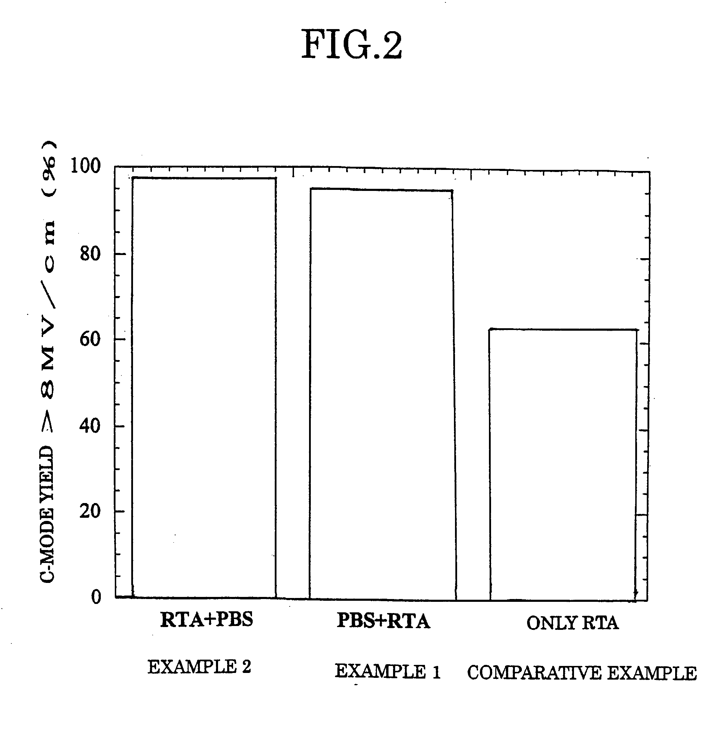

Then, the above-mentioned Si wafer was subjected to four step heat treatment at the highest temperature of 1150°C to perform CMOS simulation. MOS capacitor was then produced, and oxide dielectric breakdown voltage was measured. The result of the measurement was shown in Fig.2.

The measurement condition for the oxide dielectric breakdown voltage was as follows: thickness of the oxide film: 25 nm; electrode for measurement: phosphorus doped polysilicon film deposited electrode with a resistivity of 20□, measurement area: 0.08 cm². As for C mode good chip yield, the wafer of 8 MV/cm² or more was defined to be a good chip.

As shown in Fig.2, although the Si wafer of the present invention was contaminated by Ni, oxide dielectric breakdown voltage characteristic (C-mode good chip yield) was about 100 %. Accordingly, it is considered that the sufficient gettering effect was maintained in the wafer of the present invention.

### (Example 2)

The Si wafer was fabricated by the same method as that of Example 1 except that PBS treatment was performed after the reducing heat treatment.

Then, MOS capacitor was produced, and the oxide dielectric breakdown voltage was measured in the same manner as Example 1. The result was shown in Fig.2.

When the treatments were perforemed in the above order, the gettering effect was also maintained sufficiently.

### (Comparative example 1)

The MOS capacitor was produced by the same method as that of Example 1 except that PBS treatment was not performed, and the oxide dielectric breakdown voltage was measured. The result was shown in Fig.2.

As shown in Fig.2, in the Si wafer of Comparative Example 1, oxide dielectric breakdown voltage was significantly lowered to about 65 %. Accordingly, it is apparent that gettering effect is significantly lowered when the Si wafer is not subjected to EG.

In Examples 1 and 2 and Comparative Example 1, COP density on the front surface of the wafer was 50 or less, and the bulk defect density measured by OPP was on the order of 10⁷ number/cm³.

### Slip dislocation test

The Si wafer on which polysilicon with the thickness of 1.0 µm was formed was prepared by performing PBS treatment according to the same method as that of Example 1. Then, it was subjected to the heat treatment with RTA at each temperature of 1200°C and 1230°C for 30 seconds.

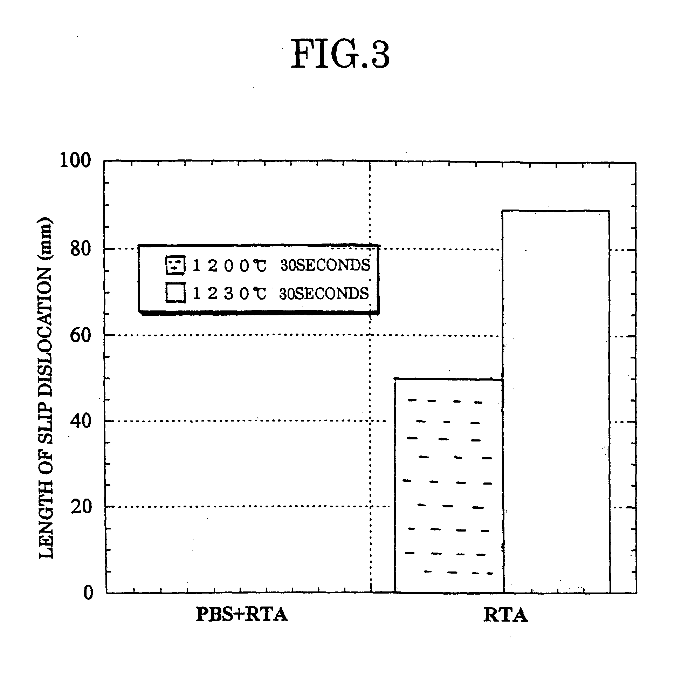

Generation of the slip dislocation on the surface of the Si wafer after the heat treatment was observed with a particle counter (LS-6000, manufactured by Hitachi Electronics Engineering). The result was shown in Fig.3.

Si wafer that was not subjected to PBS treatment was used as a control, which was subjected to the RTA heat treatment, and then the slip dislocation test was performed, as described above. The result of observation was shown in Fig.3.

As shown in Fig.3, slip dislocation was not generated on the Si wafer on which a polysilicon film was deposited, while it was generated on the Si wafer on which a polysilicon film was not deposited. Accordingly, it is apparent that polysilicon film can also suppress generation of the slip dislocation.

Previously, there has been a problem that the heat treatment at higher temperature is more effective to eliminate COPs, but slip dislocation is apt to be generated more easily. However, according to the present invention, the wafer which is good can be obtained due to the formation of a polysilicon film.

The present invention is not limited to the above-described embodiment. The above-described embodiment is a mere example, and those having the substantially same structure as that described in the appended claims and providing the similar action and effects are included in the scope of the present invention.

## Claims

1. A method for producing a Si wafer comprising at least a step of subjecting a Si wafer to extrinsic gettering and a step of subjecting a Si wafer to a heat treatment in a reducing atmosphere.

2. The method for producing a Si wafer according to Claim 1 characterized in that a step of subjecting a Si wafer to a heat treatment in a reducing atmosphere is performed after a step of subjecting a Si wafer to extrinsic gettering.

3. The method for producing a Si wafer according to Claim 1 or 2 characterized in that the extrinsic gettering is performed according to Poly-silicon Back Seal method.

4. The method for producing a Si wafer according to any one of Claims 1 to 3 characterized in that the heat treatment in a reducing atmosphere is performed with a rapid thermal annealer.

5. The method for producing a Si wafer according to any one of Claims 1 to 4 characterized in that the heat treatment in a reducing atmosphere is performed in an atmosphere of 100% hydrogen or a mixed atmosphere of hydrogen and an inert gas at 1150 to 1350°C for one to 300 seconds.

6. A Si wafer produced by the method according to any one of Claims 1 to 5.

7. The Si wafer characterized in that a COP density on the front surface of the wafer is 0.16 number/cm² or less, a bulk defect density in a bulk of the wafer is 1 x 10⁹ number/cm³ or less, and a polysilicon layer having a thickness of 0.5 µm or more exists in the back surface of the wafer.
